# EUROPEAN PATENT APPLICATION

(11) **EP 2 105 523 A1**
(43) Date of publication of application: **30.09.2009**
(21) Application number: 09002301.1
(22) Date of filing: 18.02.2009
(51) Int. Cl.: C30B 25/02, C30B 25/16, C30B 29/06

(54) **Epitaxial silicon wafer and method for its manufacturing**

(30) Priority: 26.02.2008 US 31462 P
(71) Applicant: Siltronic AG, 81737 München (DE)
(72) Inventor: Lite, Kevin, 85579 Neubiberg (DE); Tran, Quynh, 98686 Vancouver WA (US)
(74) Representative: Baar, Christian

(57) **Abstract**

An epitaxial silicon wafer is provided with a thickness in the area adjacent the edge that is greater or less than the thickness adjacent the center. The wafer may be manufactured by a method wherein one or more process parameters are adjusted during deposition of epitaxial layer to control the edge thickness.

## Description

The present invention relates to an epitaxial silicon wafer with controlled edge thickness and a method for manufacturing the wafer.

An electronic device may be formed on a silicon wafer, e.g., a power device, such as a trench power MOSFET in an epitaxial layer on the silicon wafer. Such MOSFETS are typically designed and manufactured to meet certain specifications for a maximum "on" resistance (Rdson) and a minimum breakdown voltage (BV). A wafer parameter that affects Rdson and BV is the thickness of the epitaxial layer. Ordinarily, thickness is the subject of close monitoring during wafer processing, with specifications allowing no more than ±5% variation from a target value. The upper and lower limits of the variation ordinarily differ by the same percentage from the target value. Furthermore, thickness is specified as uniform across the wafer.

During device processing, other factors, such as trench etch depth, polysilicon gate deposition, and lithographic definition, tend to be non-uniform across the wafer surface, and also affect BV within a given region.

The present disclosure is directed toward a wafer, and a method for producing the wafer where the thickness of the epitaxial layer is controlled during processing to increase or decrease the thickness in the area adjacent the edge of the wafer as compared to the area adjacent the center of the wafer. The target value for the thickness may be raised or lowered in the area adjacent the edge, either in a single step or in multiple steps proceeding out from the center of the wafer. In such cases, a chart of the thickness of a cross-section of the wafer passing through the wafer center will have a bowl-shape extending down from a high value in the area adjacent the left edge in the cross-section to a low point in the center of the cross-section, and back up to the high value in the area adjacent the right edge in the cross-section. The opposite situation is also possible whereby the edge thickness is less than that in the center of the wafer.

Process parameters may be adjusted during the deposition of the epitaxial layer to control the thickness as described.

### Brief Description of the Drawings

Fig. 1 is an overhead view of the front surface of a wafer showing examples of the locations for measurements of thickness of the epitaxial layer.
Fig. 2 is a chart of a specification for epitaxial thickness across a cross-section of a wafer for manufacture in accordance with the present disclosure, with a greater thickness near the edge of the wafer and less thickness near the center.
Fig. 3 is a chart of a specification for epitaxial thickness across a cross-section of a wafer for manufacture in accordance with the present disclosure, with a lesser thickness near the edge of the wafer and more thickness near the center.

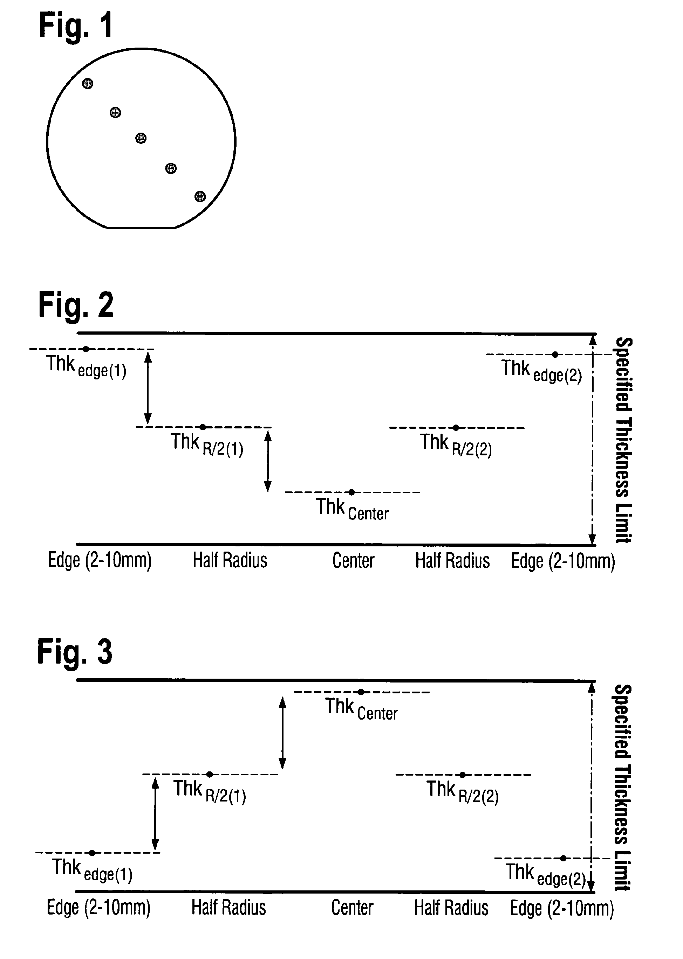

Fig. 2 shows a specification for thickness in a wafer manufacturing process. The thickness specification is shown for a cross-section intersecting the wafer's center. The x-axis of the chart represents the location on the wafer cross-section, starting at a first wafer edge, Thk_{edge(1)} at the left of the chart, passing through the wafer center (Thk_{center}) at the center of the chart, and ending at a second wafer edge, Thk_{edge(2)} at the right of the chart. Also indicated are the thicknesses at midpoints or half radii, Thk_{R/2(1)} and Thk_{R/2(2)}, on the wafer cross-section. The y-axis of the chart represents a target or limit value for thickness. As noted in the background section, previous specifications for thickness were understood to be uniform across the wafer.

In the present disclosure, thickness is specified with differing values across the wafer. Thickness (Thk_{edge(1)} and Thk_{edge(2)}) typically is greater in an area adjacent the edge of the wafer as compared to the thickness (Thk_{center}) specified in the area adjacent the wafer center. The area adjacent the wafer edge is typically considered to be the area within about 2 mm to about 10 mm from the wafer edge, although smaller or larger areas may be used for optimization with other wafer parameters.

As shown in Fig. 2, the thickness in the area adjacent the edge (Thk_{edge(1,2)}) may be increased by more than about 2% as compared to the thickness at the wafer center (Thk_{center}). As shown in Fig. 3, the thickness in the area adjacent the edge (Thk_{edge(1,2)}) may be decreased by more than about 2% as compared to the thickness at the wafer center (Thk_{center}). A greater or smaller increase or decrease in thickness may be used as appropriate for reaching the results desired in a particular application of the present disclosure. Such increase or decrease for Thk_{edge(1,2)} can be at least about 4% or even at least about 6% as compared to Thk_{center}. Of course, all thicknesses at each position are within the specified thickness limits for the epitaxial layer.

The specification may include a single change in thickness from the wafer center to the edge or may include multiple stepped changes, or a linearly or otherwise changing thickness from the center to the edge. For example, as shown in Fig. 2, the thickness increases in two steps from the center to the edge. The first step is adjacent the half radius (Thk_{R/2(1)} and Thk_{R/2(2)}), and the second is adjacent the edge (Thk_{edge(1,2)}). Fig. 3 shows thickness decreases in two steps from the center to the edge. Preferably, the value of the thickness adjacent the half radius is between the value of the thickness adjacent the center and the value of the thickness adjacent the edge. Other locations for the steps may be selected as desired to tune wafer performance for the particular application and process parameters being used. Typical locations for measuring the thickness, e.g., at the center, half-radius, and edges, are shown in Fig. 1. Additional steps beyond the two shown in Figs. 2 and 3 may also be used. The absolute and relative values of thickness at each step may also be selected for desired performance in a particular application in accordance with the present disclosure.

Thickness may be controlled by any suitable means during wafer processing. For example, selected process parameters, such as temperature or process gas flows (e.g. the flow of precursor gas like trichlorosilane (TCS) or the flow of carrier gas like hydrogen (H₂)), may be adjusted during the deposition of the epitaxial layer to control the thickness as described. The max offset temperature may be adjusted by a suitable amount, e.g., 20º C, from center to edge. In general, a higher temperature produces an increased thickness, while a lower temperature decreases thickness. Thickness may also be increased adjacent the edge, relative to the center, by increasing center injection while decreasing outside injection. Thickness may alternatively be decreased adjacent the edge, relative to the center, by decreasing center gas injection while increasing outside gas injection. Typically the change in injection will be no more than about 5%, but other adjustments may be used as suited to obtaining a desired result. Thickness may also be controlled by adjusting processing time as desired for a specific target thickness.

The thickness may be controlled in any suitable type of deposition, such as vapor-phase epitaxy, chemical vapor deposition, or other manners of depositing an epitaxial layer.

The deposition may be performed in any suitable reactor chamber or other device for producing an epitaxial layer. Preferably, the reactor is a single wafer reactor, which may also incorporate rotation of the wafer on a center axis. The reactor typically will have standard controls, such as lamp configuration, injector configuration, and others for the wafer to be adjusted from inside to outside.

Additionally, although the wafer with controlled thickness and method for producing the same and features of that wafer and method have been shown and described with reference to the foregoing operational principles and preferred embodiments, those skilled in the art will find apparent that various changes in form and detail may be made without departing from the spirit and scope of the following claims. The present disclosure is intended to embrace all such alternatives, modifications, and variances that fall within the scope of such claims.

## Claims

1. A silicon wafer defining a center, an edge, and an area adjacent the edge, the wafer including an epitaxial layer, the wafer comprising:
a first thickness of the epitaxial layer adjacent the center, and
a second thickness of the epitaxial layer in the area adjacent the edge, wherein the second thickness is changed by at least about 2% compared to the first thickness.

2. The wafer of claim 1 wherein the second thickness is at least about 2% greater than the first thickness.

3. The wafer of claim 1 wherein the second thickness is at least about 2% less than the first thickness.

4. The wafer of claim 1 wherein the second thickness is at least about 4% greater than the first thickness.

5. The wafer of claim 1 wherein the second thickness is at least about 4% less than the first thickness.

6. The wafer of any one of claims 1 to 5 wherein the area adjacent the edge is at least about 2mm and no more than about 10mm wide.

7. A method for manufacturing a silicon wafer, each wafer defining a center, a circular outer edge, an area adjacent the edge, and a front surface, the method comprising:
depositing an epitaxial layer over the front surface of the wafer, the layer having a first thickness adjacent the center, and a second thickness in the area adjacent the edge, adjusting, during the step of depositing the epitaxial layer, at least one process parameter to control the second thickness to be changed by at least about 2% compared to the first thickness.

8. The method of claim 7 wherein the second thickness is increased by at least about 2% compared to the first thickness.

9. The method of claim 7 wherein the second thickness is decreased by at least about 2% compared to the first thickness.

10. The method of any one of claims 7 to 9 wherein the process parameter is the temperature or the flow of process gas.
